Europäisches Patentamt

European Patent Office

Office européen des brevets

(11) Numéro de publication: **0 315 511**
**A1**

## (12) DEMANDE DE BREVET EUROPEEN

(21) Numéro de dépôt: 88402722.8

(22) Date de dépôt: 28.10.88

(51) Int. Cl.⁴: **H 05 K 5/03**

(30) Priorité: 29.10.87 FR 8715014

(43) Date de publication de la demande:
10.05.89 Bulletin 89/19

(84) Etats contractants désignés:
AT BE CH DE ES GB IT LI NL SE

(71) Demandeur: **OUTILLAGES SCIENTIFIQUES ET DE LABORATOIRES (O.S.L.)**
**1ère Avenue - 12ème Rue**
**F-06511 Carros Cedex (FR)**

(72) Inventeur: **Vial, Michel**
**20 Parc du Bouis Avenue Cararadoni**
**F-06000 Nice (FR)**

**Rostagni, Antoine M.**
**14, Rue L. Garneray**
**F-06300 Nice (FR)**

(74) Mandataire: **Clanet, Denis et al**
**Cabinet Beau de Loménie 55, rue d'Amsterdam**
**F-75008 Paris (FR)**

(54) **Habillage pour cadre d'appareils électroniques.**

(57) L'invention concerne un habillage pour cadre d'appareils électroniques, comportant une plaque d'embase (24) plane pourvue de deux rabats (28, 30) latéraux repliés à l'équerre vers le haut, une plaque supérieure (26) plane pourvue de deux joues latérales (32, 34) repliées à l'équerre vers le bas, la plaque supérieure étant destinée à être assemblée à l'embase de telle sorte que les joues soient reçues entre les rabats et la plaque supérieure et l'embase enfermant un volume parallélépipédique de dimensions légèrement supérieures au cadre à habiller, caractérisé en ce qu'il comporte en outre plusieurs réglettes (40) verticales de blocage destinées à maintenir assemblées l'embase et la plaque supérieure, lesdites réglettes comportant deux ailes verticales (42, 44) séparées par une fente (46) capable de recevoir ensemble les bordures latérales des joues et des rabats, ainsi qu'une bordure d'un montant (20, 22) latéral vertical du cadre.

Fig. 2

Bundesdruckerei Berlin

EP 0 315 511 A1

# Description

## HABILLAGE POUR CADRE D'APPAREILS ELECTRONIQUES

La présente invention concerne un habillage pour cadre d'appareils électroniques.

Actuellement, les appareils électroniques sont le plus souvent constitués par des cadres parallé-lépipédiques dans lesquels sont montées des cartes de circuits imprimés portant les composants électroniques et leurs connexions.

Ces cartes sont reçues dans le cadre par l'intermédiaire de glissières.

Selon la complexité de l'installation, un appareil peut être constitué de plusieurs cadres superposés et/ou juxtaposés dans des armoires ou baies comportant un châssis portant un habillage extérieur et définissant plusieurs alvéoles dans lesquelles sont glissés les cadres, de telle sorte que seules les façades des cadres sont visibles, ou encore être constitué d'un seul cadre. Dans ce dernier cas, on glisse habituellement le cadre dans un coffret, à la fois pour des raisons esthétiques et pour éviter l'introduction d'objets entre les cartes de circuits imprimés.

Cependant, les coffrets individuels sont constitués par assemblage de nombreuses pièces et relativement coûteux.

De plus, on peut avoir besoin, lorsque les cadres sont montés en baie, de disposer autour d'un cadre, ou de plusieurs d'entre eux, des plaques de blindage électromagnétique. Dans le meilleur des cas, la solution consiste à rapporter des plaques de blindage sur toutes les faces du cadre, mais parfois, si un tel blindage n'a pas été prévu dès la conception, il peut s'avérer nécessaire de remplacer après assemblage le cadre prévu à l'origine par un cadre adéquat.

La présente invention a donc pour but de proposer un habillage pour cadre d'appareils électroniques qui permette de réaliser aussi bien un coffret économique et simple à assembler, qu'un blindage électromagnétique susceptible d'être rajouté après assemblage à un cadre destiné à être monté en baie.

Selon l'invention, l'habillage comporte une plaque d'embase plane pourvue de deux rabats latéraux repliés à l'équerre vers le haut, une plaque supérieure plane pourvue de deux joues latérales repliées à l'équerre vers le bas, la plaque supérieure étant destinée à être assemblée à l'embase de telle sorte que les joues soient reçues entre les rabats et la plaque supérieure et l'embase enfermant un volume parallélépipédique de dimensions légèrement supérieures au cadre à habiller ; cet habillage est caractérisé en ce qu'il comporte en outre plusieurs réglettes verticales de blocage destinées à maintenir assemblées l'embase et la plaque supérieure, lesdites réglettes comportant deux ailes verticales séparées par une fente capable de recevoir ensemble les bordures latérales des joues et des rabats, ainsi qu'une bordure d'un montant latéral vertical du cadre.

Selon une autre caractéristique de l'invention, les réglettes comportent des languettes horizontales, aux extrémités de l'une des ailes, séparées par une distance égale à la hauteur totale depuis l'embase jusqu'à la plaque supérieure.

L'invention prévoit également que les réglettes soient montées par encliquetage sur le cadre.

En particulier, les bordures des montants latéraux verticaux du cadre sont pourvues d'évidements à entrée rétrécie et les réglettes comportent des bossages déformables reçus dans lesdits évidements.

En complément, la plaque d'embase et la plaque supérieure peuvent être rendues solidaires l'une de l'autre au moyen de vis coopérant avec les rabats de l'embase et les joues de la plaque supérieure.

D'autres détails et avantages de l'invention apparaitront clairement à la lecture de la description qui va suivre, en se référant aux dessins annexés, dans lesquels :

    - la figure 1 est une vue en perspective éclatée d'un cadre d'appareil électronique et d'une partie d'un habillage selon l'invention ;

    - la figure 2 est une vue en perspective d'un détail de la figure 1, illustrant l'habillage en condition assemblée ; et

    - les figures 3a, 3b sont des vues d'une réglette de l'habillage.

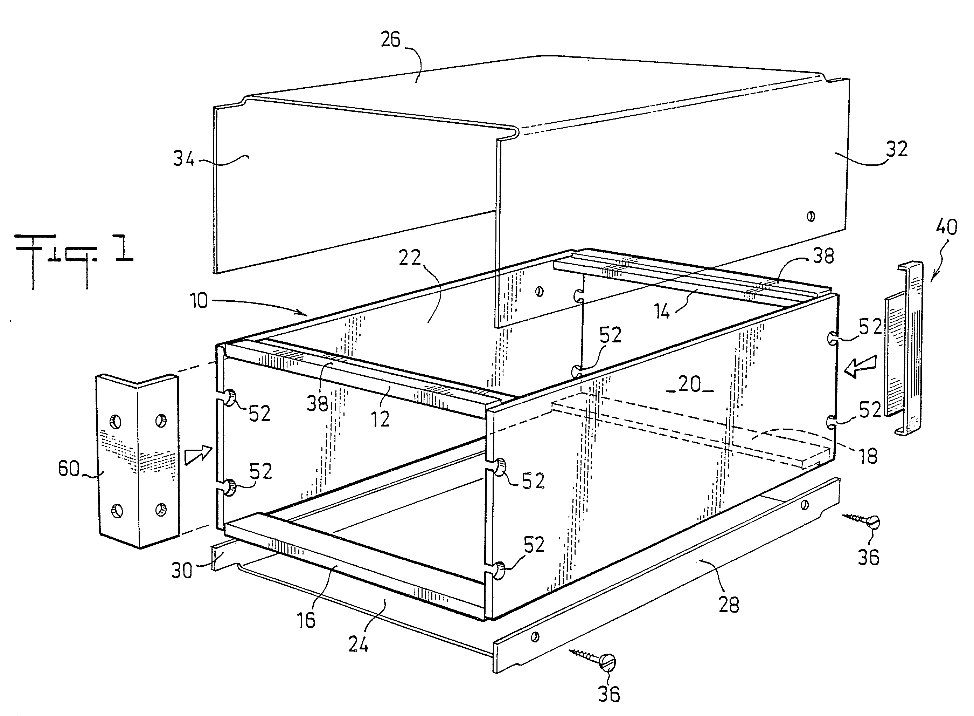

Se reportant à la figure 1, un cadre parallélépipédique 10 pour appareil électronique est représenté en traits gras. Il se comporte de deux traverses supérieures frontale 12 et postérieure 14 et de deux traverses inférieures frontale 16 et postérieure 18, fixées à leurs extrémités à des flasques latéraux 20 et 22, formant montants du cadre.

Comme connu, le cadre est destiné à recevoir des cartes de circuit imprimé insérées verticalement entre des glissières longitudinales supérieures et inférieures, mais pour simplifier la figure ni les cartes ni leurs glissières n'ont été représentées.

Un habillage, destiné à protéger les cartes et en règle générale tous les composants ou circuits électroniques montés dans le cadre et éventuellement à conférer un aspect esthétique à l'appareil, ou encore à constituer un écran électromagnétique autour du cadre, est composé d'une plaque d'embase 24 et d'une plaque supérieure 26 représentées en traits fins à la figure 1 et en cours d'assemblage sur le cadre 10.

La plaque d'embase 24, horizontale, est munie sur ses deux côtés de rabats 28, 30, repliés à l'équerre vers le haut, et la plaque supérieure 26, horizontale également, est munie de deux joues latérales 32, 34 repliées à l'équerre vers le bas.

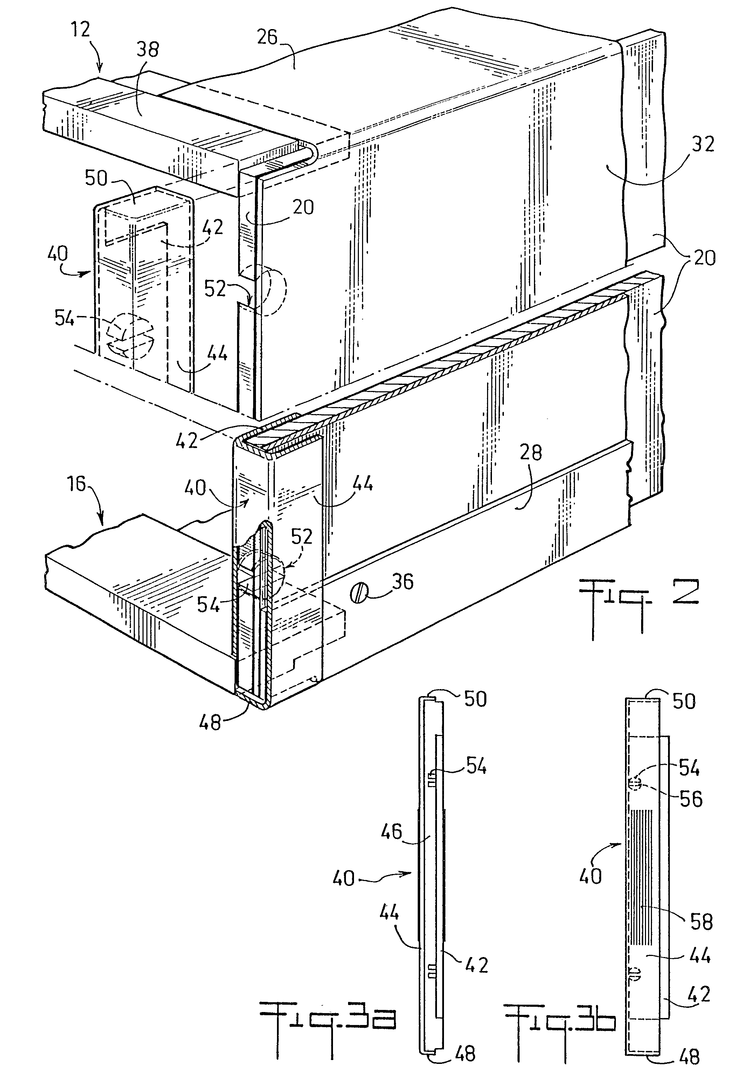

La hauteur des joues 32, 34 est sensiblement égale à la hauteur des flasques latéraux du cadre, tandis que les rabats 28, 30 sont d'une hauteur inférieure, suffisante pour assurer un recouvrement des parties basses des joues et permettre la solidarisation de la plaque d'embase et de la plaque supérieure au moyen de vis 36 (Figure 2).

Comme représenté, les parties horizontales des deux plaques sont légèrement plus courtes que le cadre dans la direction avant/arrière et les traverses présentent des zones en surépaisseur 38, de telle sorte que les plaques viennent s'encastrer entre les surépaisseurs des deux traverses frontale et postérieure, ce qui assure un blocage de l'habillage par rapport au cadre dans la direction avant/arrière.

En complément de l'assemblage par vis 36 ou, le cas échéant, en remplacement de cet assemblage, l'habillage comporte des réglettes verticales 40, au nombre de quatre, destinées à bloquer l'habillage contre le cadre le long des quatre arêtes verticales du cadre parallélépipédique.

Comme illustré sur les deux vues interne et latérale des figures 3a et 3b, chaque réglette, réalisée de préférence en matière plastique, comporte deux ailes 42, 44, séparées par une fente 46 destinée à recevoir ensemble les bordures verticales d'un flasque, d'une joue de la plaque supérieure et d'un rabat de la plaque d'embase.

L'aile intérieure 42 occupe sensiblement toute la hauteur séparant les deux traverses frontales, tandis que l'aile extérieure 44 occupe une hauteur légèrement supérieure à la hauteur totale de l'habillage une fois assemblé.

Cette aile extérieure se termine à ses deux extrémités par deux languettes horizontales 48, 50 séparées par une distance égale à la hauteur totale depuis l'embase jusqu' à la plaque supérieure, destinées à recouvrir les coins supérieur et inférieur de l'habillage et des traverses.

Selon l'invention, les réglettes sont maintenues en place par encliquetage. A cet effet, les bordures verticales de flasques sont pourvues de deux évidements 52 à entrée rétrécie, par exemple des évidements circulaires ménagés à une distance de la bordure inférieure à leur rayon.

La réglette comporte entre ses ailes des bossages 54 de forme complémentaire aux évidements. Ces bossages sont déformables afin de permettre leur passage par l'entrée rétrécie des évidements, grâce à une fente 56 ménagée dans la partie centrale des bossages.

Bien entendu, le nombre de bossages et d'évidements sera fonction de la hauteur du cadre, donc de la réglette. Pour une faible hauteur, un seul bossage pourra être suffisant>

Comme illustré, les bossages n'occupent pas toute la largeur entre les ailes de la réglette, ce qui permet de recevoir librement la bordure de la joue et du rabat sans qu'il soit besoin de prévoir dans ces derniers des évidements analogues aux évidements 52. En effet, les techniques usuelles de tôlerie permettraient difficilement d'obtenir une parfaite coïncidence entre les évidements des flasques et des plaques d'habillage.

Enfin, les faces extérieures des ailes sont pourvues des stries 58 qui permettent de saisir la réglette à la main pour l'engager ou l'extraire.

Bien entendu, les matériaux utilisés pour réaliser la plaque d'embase et la plaque supérieure et leur finition seront choisis en fonction des résultats recherchés : protection mécanique, effet esthétique, écran électromagnétique. Il en sera de même pour les réglettes verticales.

On aura compris à la lecture de ce qui précède que l'invention permet de réaliser très simplement un habillage autour d'un cadre d'appareil électronique, aussi bien pour munir un appareil formé par un cadre unique d'un coffret de protection à vocation esthétique, que pour munir un cadre logé dans une baie d'un écran électromagnétique même lorsqu'un tel écran n'a pas été prévu dès la conception.

Dans ce dernier cas, on notera que les deux réglettes correspondant aux arêtes verticales frontales du cadre seront remplacées par deux équerres fixées par une aile sur le flasque de cadre et par l'autre aile sur un montant de la baie, comme cela est habituel pour les appareils montés en baie. Une telle équerre 60 est représentée à la figure 1.

Enfin, l'habillage selon l'invention peut être aisément déposé, sans outillage spécifique, afin de procéder à toute intervention à l'intérieur du cadre, ou encore pour être remplacé par un autre habillage si nécessaire.


**Revendications**

1. Habillage pour cadre d'appareils électroniques, comportant une plaque d'embase (24) plane pourvue de deux rabats (28, 30) latéraux repliés à l'équerre vers le haut, une plaque supérieure (26) plane pourvue de deux joues latérales (32, 34) repliées à l'équerre vers le bas, la plaque supérieure étant destinée à être assemblée à l'embase de telle sorte que les joues soient reçues entre les rabats et la plaque supérieure et l'embase enfermant un volume parallélépipédique de dimensions légèrement supérieures au cadre à habiller, caractérisé en ce qu'il comporte en outre plusieurs réglettes (40) verticales de blocage destinées à maintenir assemblées l'embase et la plaque supérieure, lesdites réglettes comportant deux ailes verticales (42, 44) séparées par une fente (46) capable de recevoir ensemble les bordures latérales des joues et des rabats, ainsi qu'une bordure d'un montant (20, 22) latéral vertical du cadre.

2. Habillage selon la revendication 1, caractérisé en ce que les réglettes comportent des languettes horizontales (48, 50) aux extrémités de l'une des ailes (42, 44).

3. Habillage selon la revendication 1 ou la revendication 2, caractérisé en ce que les réglettes sont réalisées en matière plastique.

4. Habillage selon l'une quelconque des revendications 1 à 3, caractérisé en ce que les réglettes sont montées par encliquetage sur le cadre.

5. Habillage selon la revendication 5, caractérisé en ce que les bordures des montants latéraux du cadre sont pourvues d'évidements (52) à entrée rétrécie et en ce que les réglettes comportent des bossages (54) déformables reçus dans lesdits évidements.

6. Habillage selon la revendication 6, caractérisé en ce que lesdits bossages (54) comportent une fente (56) ménagée dans leur partie centrale.

7. Habillage selon la revendication 5 ou la revendication 6, caractérisé en ce que lesdits bossages (54) occupent seulement une partie de la largeur entre les ailes de la réglette.

8. Habillage selon l'une quelconque des revendications 5 à 7, caractérisé en ce que les évidements consistent en des évidements circulaires ménagés à une distance de la bordure du cadre inférieure à leur rayon.

9. Habillage selon l'une quelconque des revendications 1 à 8, caractérisé en ce que la plaque d'embase et la plaque supérieure sont réalisées en un matériau formant écran électromagnétique.

10. Habillage selon l'une quelconque des revendications 1 à 8, caractérisé en ce que la plaque d'embase et la plaque supérieure sont réalisées en un matériau à vocation esthétique.

Fig. 1

Fig. 2

Fig.3a  Fig.3b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-2 858 179 (G.O. PUERNER et al.) <br> * figures 1 - 3 * <br> --- | 1 | H 05 K 5/03 |
| A | DE-A-2 257 695 (SIEMENS) <br> * page 7, lignes 20 - 25; figure 1 * <br> --- | 1 | |
| A | DE-A-3 010 159 (CIT-ALCATEL) <br> * page 8, ligne 20 - page 9, ligne 24; figures 1 - 3 * <br> ----- | 1 | |

DOMAINES TECHNIQUES
RECHERCHES (Int. Cl.4)

H 05 K 5/00
H 05 K 7/00
H 05 K 9/00

Le présent rapport a été établi pour toutes les revendications

| Lieu de la recherche | Date d'achèvement de la recherche | Examinateur |
|---|---|---|
| BERLIN | 23-01-1989 | LEOUFFRE M. |

EPO FORM 1503 03.82 (P0402)